# EUROPEAN PATENT APPLICATION

(11) **EP 4 757 092 A1**
(43) Date of publication of application: **10.06.2026**
(21) Application number: 24849383.5
(22) Date of filing: 27.06.2024
(51) Int. Cl.: H02H 7/20, H02H 9/00, H03K 17/693

(54) **SEMICONDUCTOR CIRCUIT BREAKER INCLUDING POWER SEMICONDUCTOR SWITCH, AND POWER SUPPLY DEVICE COMPRISING SEMICONDUCTOR CIRCUIT BREAKER**

(30) Priority: 28.07.2023 KR 20230099142
(71) Applicant: LS Electric Co., Ltd., Gyeonggi-do 14119 (KR)
(72) Inventor: YUN, Dongjin, Anyang-si Gyeonggi-do 14118 (KR); KIM, Seongeon, Anyang-si Gyeonggi-do 14118 (KR)
(74) Representative: K&L Gates LLP
(86) International application number: PCT/KR2024/009019
(87) International publication number: WO 2025/028812

(57) **Abstract**

The present invention relates to a semiconductor circuit breaker comprising: a semiconductor switch unit which is arranged at an input electric circuit through which current is supplied from a power source to a load, and which includes at least one semiconductor switch for opening or closing the input electric circuit; a control unit, which controls a gate driver of the at least one semiconductor switch so as to control the opening or closing of the input electric circuit; and at least one inductor which is a separate electric circuit from the input electric circuit having the semiconductor switch unit arranged thereon, and which is arranged at a feedback electric circuit through which the current that is output from the load is fed back to the power source.

## Description

### Technical Field

The disclosure relates to a semiconductor circuit breaker including a power semiconductor switch for controlling power supplied to a load or another system, and a power supply system including a plurality of power sources connected through the semiconductor circuit breaker.

### Background Art

In the case of a conventional mechanical breaker, there was a problem that a relatively long time of a few tens of msec was required until a circuit was broken, and an abnormal current was introduced to a load for the time. Therefore, a power supply device including a semiconductor circuit breaker (solid state circuit breaker (SSCB)) currently appears, which enables high-speed current breaking, including a switch made of a power semiconductor that enables conduction of high current and has a high-speed switching frequency. The semiconductor circuit breaker electrically breaks a circuit connection, using the power semiconductor switch, and thus has an advantage that a circuit breaking speed thereof is very fast.

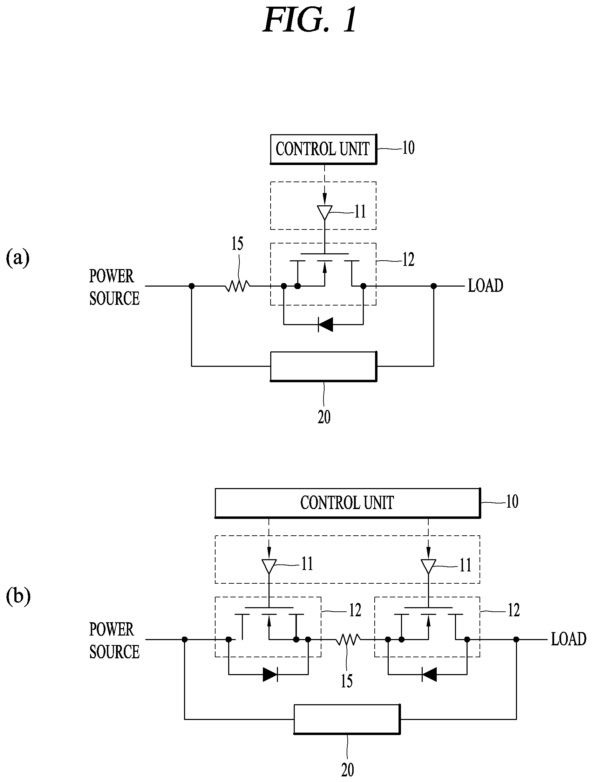

FIG. 1 illustrates an example of a power supply circuit including such a conventional semiconductor circuit breaker. FIG. 1A illustrates a case where only one semiconductor switch is provided, and FIG. 1B illustrates a case where two semiconductor switches are provided.

First, referring to FIG. 1A, the conventional semiconductor circuit breaker may include a semiconductor switch 12 including a power semiconductor, a gate driver 11 for applying a gate voltage to a gate terminal of the semiconductor switch 12, and a control unit 10 for controlling the gate driver 11.

The conventional semiconductor circuit breaker may include an inductor 15 connected in series to the semiconductor switch 12. Here, the inductor 15 is used to limit the rise rate (di/dt) of current supplied from a power source to a load, and delays a time for which, when an abnormal current such as a leakage current or a short circuit current occurs, the amplitude of the abnormal current reaches a maximum value, so that the load can be broken from the power source before the current magnitude increased by the abnormal current reaches a maximum value. In addition, the rising speed of current is slowed down, so that the occurrence of the abnormal current can be more accurately detected.

Meanwhile, the rise rate of current may be further limited as the inductance of the inductor 15 becomes larger. Therefore, it may be more effective that an inductor having a large inductance is used. However, the inductance may become larger as the sectional area of a core becomes wider and as the number of windings of a conducting wire wound around the core becomes larger. That is, as the inductance becomes larger, the protection effect of the load or the semiconductor switch 12 or the detection accuracy of the abnormal current may be improved. Therefore, in order to substantially obtain an effect according to the inductance, the inductor 15 should have at least constant or larger inductance.

However, as shown in FIGS. 1A and 1B, the conventional semiconductor circuit breaker has a configuration in which the inductor 15 is successively connected to the semiconductor switch 12 in front of the semiconductor switch 12 or between the plurality of semiconductor switches 12. As such, sine the conventional semiconductor circuit breaker has an integrated configuration in which the inductor 15 is successively connected to the semiconductor switch 12, there is a problem that the size of the conventional semiconductor circuit breaker is increased due to the volume of the inductor 15 having the constant or larger inductance.

In addition, when the power source and the load are electrically connected to each other as the semiconductor switch 12 is on, the inductor 15 may generate a magnetic field and charge energy. On the other hand, when the electrical connection between the power source and the load is broken as the semiconductor switch 12 is off, the flow of current applied to the inductor 15 may be suspended, and the magnetic field generated in the inductor 15 may be extincted. In this case, the extincted magnetic field induces a current flowing in the opposite direction of the flow of current. That is, a counter electromotive force is generated.

Due to the counter electromotive force, a voltage much higher than a voltage applied to the inductor 15 is instantaneously formed at both ends of the semiconductor switch 12. In addition, there is a problem that when a spark caused by the counter electromotive force is generated, electronic components connected to the circuit may be damaged.

In order to solve the problem of the counter electromotive force, the conventional semiconductor circuit breaker includes a separate circuit 20, e.g., a freewheeling circuit or a flyback circuit, including at least one resistor between both the ends of the semiconductor switch 12. In addition, the conventional semiconductor circuit breaker enables the counter electromotive force to be eliminated through the separate circuit 20. Therefore, since the conventional semiconductor circuit breaker includes not only the semiconductor switch 12 but also the inductor 15 and the separate circuit 20 for eliminating the counter electromotive force, there is a problem that the size of the conventional semiconductor circuit breaker is increased.

### Disclosure of Invention

### Technical Problem

Therefore, to obviate those problems, an aspect of the detailed description is to provide a semiconductor circuit breaker having a structure that can be more effectively arranged according to a shape or space in which an electric circuit is arranged.

Another aspect of the detailed description is to provide a compact power supply system in which an inductor is arranged on an electric circuit separate from an electric circuit on which a semiconductor switch unit is arranged, so that the inductor and a circuit for eliminating a counter electromotive force are separated from the semiconductor switch unit in the power supply system having a plurality of power sources.

### Solution to Problem

To achieve these and other advantages and in accordance with the purpose of the disclosure, as embodied and broadly described herein, there is provided a semiconductor circuit breaker including a semiconductor switch unit arranged on an input electric circuit through which current is supplied from a power source to a load, and including at least one semiconductor switch that opens or closes the input electric circuit; a control unit configured to a gate driver of the at least one semiconductor switch, thereby controlling the opening or closing of the input electric circuit; and at least one inductor arranged on a feedback electric circuit through which the current output from the load is fed back to the power source, as an electric circuit separate from the input electric circuit on which the semiconductor switch unit is arranged

In an embodiment, the input electric circuit may be a positive (P)-phase electric circuit which is a live line, and the feedback electric circuit may be a negative (N)-phase electric circuit which is a neutral line.

In an embodiment, the at least one inductor may be arranged between an output terminal of the load and the power source, and may be connected in series to the load at a rear end of the load.

In an embodiment, the at least one semiconductor switch may include a rectifying element arranged in a direction opposite to a direction in which the semiconductor switch is arranged, and the rectifying element may include at least one of a diode, a rectifier, or a thyristor.

In an embodiment, the semiconductor switch may be configured as an insulated gate bipolar transistor (IGBT) or a metal oxide semiconductor field effect transistor (MOSFET).

In an embodiment, a counter electromotive force elimination circuit for eliminating a counter electromotive force generated when current supply is suspended due to off of the semiconductor switch may be further arranged on an electric circuit different from the electric circuit on which the semiconductor switch unit is arranged.

In an embodiment, the counter electromotive force elimination circuit may be connected to both ends of the inductor arranged on an electric circuit different from the electric circuit on which the semiconductor switch unit is arranged, and may include at least one diode having a polarity arranged in a direction opposite to a direction the current flows through the electric circuit on which the inductor is arranged.

In an embodiment, a link capacitor connected in parallel to the power source may be further arranged between the input electric circuit and the feedback electric circuit.

In an embodiment, the semiconductor switch unit may include first and second semiconductor switches arranged between a first power system and a second power system, connected in series to each other, and arranged in directions opposite to each other. Any one of the first power system and the second power system may be a power source that supplies current to the other of the first power system and the second power system, and the other of the first power system and the second power system may operate as a load supplied with the current from the one of the first power system and the second power system.

In an embodiment, the inductor may be a variable inductor in which a change in inductance thereof is possible. When the load is changed, the control unit may change the inductance of the variable inductor such that a total inductance obtained by summing up an inductance of the changed load and the inductance of the variable inductor forms a predetermined inductance.

In an embodiment, the load may be an inductive load.

To achieve these and other advantages and in accordance with the purpose of the disclosure, as embodied and broadly described herein, there is provided a power supply system including a bus configured to connect a plurality of power sources in parallel to each other, and connect the plurality of power sources connected in parallel to each other and a load; a plurality of semiconductor switch units arranged between the respective power sources and the bus, and each including at least one semiconductor switch that opens or closes an electric circuit through which current is supplied from each power source to the bus; a control unit configured to control gate drivers of the semiconductor switches respectively included in the plurality of semiconductor switch units, thereby controlling the opening or closing of each electric circuit through which the current is supplied from the power source to the bus; and a common inductor arranged at an output terminal of the load, and providing an inductance commonly applied to the plurality of semiconductor switch units.

In an embodiment, the power supply system may further include a counter electromotive force elimination circuit connected to both ends of the common inductor, and including at least one diode having a polarity arranged in a direction opposite to a direction the current flows through the electric circuit on which the common inductor is arranged.

In an embodiment, a first power source among the plurality of power sources may include two or more energy storage systems connected in series to each other, and a semiconductor switch unit arranged between the first power source and the bus may be arranged in the middle of the two or more energy storage systems connected in series to each other.

In an embodiment, the control unit may differently control a duty rate which is a rate of a time for which the semiconductor switch unit is on and a time for which the semiconductor switch unit is off during a predetermined time according to the plurality of power sources such that a ratio of amounts of current that the plurality of power sources supply to the load is changed.

### Advantageous Effects of Invention

According to at least one of the embodiments of the disclosure, in the disclosure, there is an effect that an inductor is separated from a semiconductor switch unit, thereby allowing the semiconductor switch unit and the inductor to be arranged on different electric circuits, so that the semiconductor circuit breaker can be arranged by more efficiently utilizing a shape or space in which an electric circuit is arranged.

Also, in the disclosure, there is an effect that a sufficient space for arranging an inductor is secured, thereby enabling an inductor having a larger inductance to be used, and the use of an inductor having a large-capacity inductance is possible, so that a power supply system in which semiconductor switches connected to a plurality of power sources commonly use one inductor can be implemented.

Also, in the disclosure, there is an effect that an inductor is arranged on a current output line of a load, through which current is output from the load, so that an inductance obtained by summing up an inductance of the inductor and an inductance of the load can be formed. Thus, there is an effect that since an inductance larger than the inductance of the inductor can be formed, the load and the semiconductor switch can be further protected or the detection accuracy of an abnormal current can be further improved.

Also, in the disclosure, the inductance of an inductor varies according to a load, so that when the load is changed, the inductance of the inductor can vary according to the inductance of the changed load. Thus, there is an effect that the inductance of the semiconductor circuit breaker can maintain a constant value regardless of the change in the load.

### Brief Description of Drawings

FIG. 1 is a block diagram illustrating a configuration of a conventional semiconductor circuit breaker.
FIG. 2 is a block diagram illustrating a structure of a semiconductor circuit breaker according to an embodiment of the disclosure.
FIG. 3 is a conceptual diagram illustrating a concept in which a load and an inductor form one inductor in the semiconductor circuit breaker according to the embodiment of the disclosure.
FIG. 4 is a block diagram illustrating a configuration of a power supply system in which semiconductor switch units connected to a plurality of power source units commonly use one inductor according to an inductor separable structure of the semiconductor circuit breaker according to an embodiment of the disclosure.
FIG. 5 is a block diagram illustrating a configuration of a semiconductor circuit breaker including a semiconductor switch unit capable of controlling bidirectional current flow.
FIG. 6 is an exemplary diagram illustrating an example in which current is supplied from system A to system B in the semiconductor circuit breaker of FIG. 5.
FIG. 7 is an exemplary diagram illustrating an example in which current is supplied from the system B to the system A in the semiconductor circuit breaker of FIG. 5.

### Mode for the Invention

Technical terms used in this specification are used to describe only specific embodiments, and it is to be noted that the terms are not intended to limit the disclosure. Furthermore, an expression of the singular number used in this specification includes an expression of the plural number unless clearly defined otherwise in the context. In this application, terms, such as "comprise" and "include," should not be interpreted as essentially including all several elements or several steps described in the specification and should be interpreted as not including some of the elements or steps or as including additional element or steps.

In describing the embodiments disclosed herein, the detailed description will be omitted when specific description for publicly known technologies to which the disclosure pertains is judged to obscure the gist of the disclosure.

Hereinafter, embodiments disclosed in this specification will be described in detail with reference to the accompanying drawings.

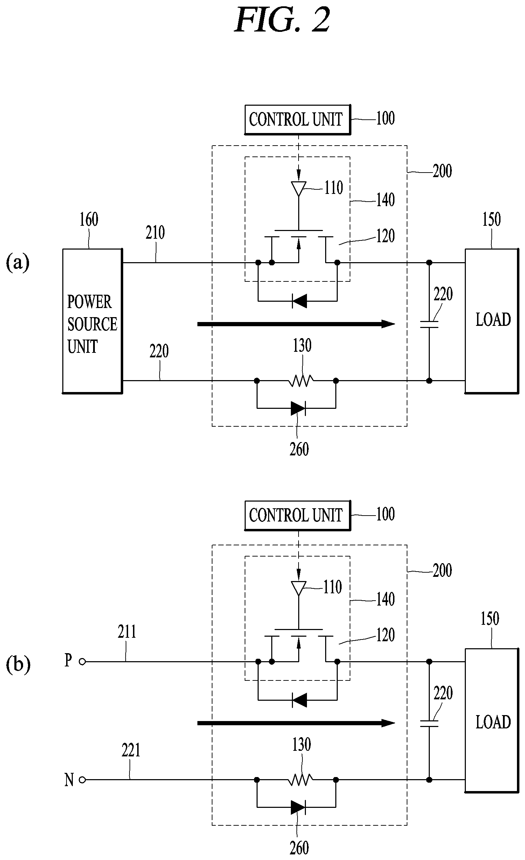

FIG. 2 is a block diagram illustrating a structure of a semiconductor circuit breaker 200 according to an embodiment of the disclosure.

First, FIG. 2A is a block diagram illustrating a power source unit 160 that supplies current to a load 150 and a configuration of the semiconductor circuit breaker 200 according to the embodiment of the disclosure, arranged on an electric circuit that supplies the current between the power source unit 160 and the load 150.

As shown in FIG. 2A, the power source unit 160 and the load 150 may constitute a closed circuit. That is, a closed circuit may be formed in which the current is supplied to the load 150 through an electric circuit (hereinafter, referred to as an input electric circuit 210) through which the current is input from the power source unit 160 to the load 150, and the current output from the load 150 is again supplied to the power source unit 160 through an electric circuit (hereinafter, referred to as a feedback electric circuit 220) through which the current is output from the load 150 to be fed back to the power source unit 160. Only in a state in which the circuit is closed, the current of the power source unit 160 may be supplied to the load 150.

Meanwhile, as shown in FIG. 2A, the semiconductor circuit breaker 200 according to the embodiment of the disclosure may include a semiconductor switch unit 140 arranged on the input electric circuit 210 through which the current is supplied from the power source unit 160 to the load 150, a control unit 100 that controls the semiconductor switch unit 140, and at least one inductor 130 arranged on the feedback electric circuit 220 through which the current is introduced from the load 150 to the power source unit 160.

Here, the semiconductor switch unit 140 may include at least one semiconductor switch 120 formed using a power semiconductor and a gate driver 110 that apply a gate voltage to a gate terminal of each semiconductor switch 120. In addition, the semiconductor switch 120 may include a source (or collector) terminal, a drain (or emitter) terminal, and a gate (or base) terminal of the power semiconductor. Here, the semiconductor switch 120 may be configured as an insulated gate bipolar transistor (IGBT) or a metal oxide semiconductor field effect transistor (MOSFET).

Also, the semiconductor switch unit 140 may include a rectifying element that is connected in parallel to each semiconductor switch 120 and is located in a direction opposite to current flow caused by the semiconductor switch 120. Here, the rectifying element may include at least one of a diode, a rectifier (e.g., a bridge rectifier), or a thyristor.

Meanwhile, when the gate voltage equal to or higher than a predetermined threshold voltage is applied to the semiconductor switch 120 from the gate driver 110 according to characteristics of the power semiconductor, the source terminal and the drain terminal may be electrically connected to each other. Therefore, when the gate voltage equal to or higher than the threshold voltage is applied to the gate terminal, electricity may be conducted through the semiconductor switch 120.

Meanwhile, as shown in FIG. 2A, when the semiconductor switch unit 140 is composed of one semiconductor switch 120, the source terminal of the semiconductor switch 120 may be connected to a side of the power source unit 160. On the other hand, the drain terminal of the semiconductor switch 120 may be connected to a side of the load 150. Accordingly, when the gate voltage equal to or higher than the threshold voltage is applied to the gate terminal, the source terminal and the drain terminal are electrically connected to each other, and therefore, the input electric circuit 210 that connects the power source unit 160 and the load 150 through the semiconductor switch120 may be formed. In addition, the current of the power source unit 160 may be supplied to the load 150 along the formed input electric circuit 210.

Meanwhile, the control unit 100 may control the gate driver 110, thereby controlling the gate voltage that the gate driver 110 applied to the gate terminal. For example, when the control unit 100 is normally driven, the control unit 100 may control the gate driver 110 to apply the gate voltage equal to or higher than the predetermined threshold voltage. Therefore, the source terminal and the drain terminal of the semiconductor switch 120 may be conducted, and power of the power source unit 160 may be supplied to the load 150 through the input electric circuit 210.

In a state in which the source terminal and the drain terminal are conducted as described above, the control unit 100 may detect current flowing in the input electric circuit 210 or the feedback electric circuit 220. Also, the control unit 100 may determine whether or not an abnormal current due to a short circuit or current leakage occurs according to a detection result. When it is determined that the abnormal current occurs, the control unit 100 may control the gate driver 110 to apply the gate voltage less than the threshold voltage or not to apply the gate voltage.

Then, the electrical connection between the source terminal and the drain terminal may be broken, and the supply of the current from the power source unit 160 to the load 150 may be suspended as the input electric circuit 210 is opened. Thus, the abnormal current can be prevented from being supplied to the load 150.

Meanwhile, in the semiconductor circuit breaker 200 according to the embodiment of the disclosure, the inductor 130 may be separated from the semiconductor switch unit 140 to be arranged on another electric circuit as shown in FIG. 2A. That is, while the semiconductor switch unit 140 including the semiconductor switch is arranged on the input electric circuit 210 through which the current is supplied from the power source unit 160, the inductor 130 may be arranged on the feedback electric circuit 220 through which the current is fed back from the load 150. Therefore, as shown in FIG. 2A, the inductor 130 of the semiconductor circuit breaker 200 according to the embodiment of the disclosure may be arranged on an electric circuit different from the electric circuit on which the semiconductor switch unit 140 is arranged. For example, the inductor 130 may be located between an output terminal of the load 150 and the power source unit 160.

Meanwhile, in a case where the inductor is provided in the semiconductor circuit breaker, the inductor charges energy and generates a magnetic field when the semiconductor switch unit is on. On the contrary, the magnetic field extincted according to Lenz's law induces a reverse current when the semiconductor switch unit is off. Therefore, as a negative potential is generated in the inductor in which a positive potential existed, the reverse current may be generated, and a voltage, i.e., a counter electromotive force, which is much higher than a voltage instantaneously applied to the inductor, may be formed between both ends of the semiconductor switch unit. In addition, the counter electromotive force is a voltage spark is generated by the inductor, and may cause damage of a system due to high voltage.

Accordingly, like the conventional semiconductor circuit breaker described in FIG. 1, when the semiconductor switch unit and the inductor are arranged on one electric circuit, a separate circuit, e.g., a flyback circuit or a freewheeling is to be provided so as to eliminate the counter electromotive force. In addition, the separate circuit is an additional component added apart from the semiconductor switch unit, and becomes a factor that increases the size of the semiconductor circuit breaker.

However, as described above, the counter electromotive force is generated to consume energy stored in the inductor when current supply is suddenly interrupted, and may be eliminated when a path through which the current of the inductor can flow is formed between both ends of the inductor.

Thus, the counter electromotive force can be eliminated in a case where a circuit including a flyback diode, a freewheeling diode, or a catch diode, arranged in a direction opposite to the flow of current flowing in the inductor when the semiconductor switch unit 140 is on, is located between both the ends of the inductor.

However, in the semiconductor circuit breaker 200 according to the embodiment of the disclosure, the inductor 30 is arranged on an electric circuit separate from the electric circuit on which the semiconductor switch unit 140 is arranged as shown in FIG. 2A. Thus, a separate circuit 260 for eliminating the counter electromotive force, e.g., a flyback circuit or a freewheeling circuit is arranged on the electric circuit on which the inductor 130 is arranged, to be separated from the semiconductor switch unit 140. In this case, the polarity of a diode arranged in the counter electromotive force elimination circuit 260 is arranged in a direction opposite to flow in which the current is fed back through the feedback electric circuit, i.e. current flow from the load 150 to the power source unit 160. That is, as shown in FIG. 2A, the diodes of the counter electromotive force elimination circuit may be arranged in the same direction as the direction in which the current flows through the input electric circuit 210.

As such, in the disclosure, the inductor 130 and the counter electromotive elimination circuit 260 of the semiconductor circuit breaker 200 may be arranged on an electric circuit different from the electric circuit on which the semiconductor switch unit 140 is arranged. Thus, the inductor and the counter electromotive force elimination circuit are arranged to be separated from the semiconductor switch unit according to a shape or space in which the electric circuits connected to the load 150 are arranged, so that a space can be more efficiently utilized. That is, the input electric circuit 210 is very narrow, only the semiconductor switch unit 140 of the semiconductor circuit breaker 200 according to the embodiment of the disclosure is arranged on the input electric circuit 210, and the inductor 130 and the counter electromotive force elimination circuit 260 are arranged on the feedback electric circuit 220, so that the semiconductor circuit breaker can be arranged even in a space or environment in which it is difficult for the existing semiconductor circuit breakers to be arranged.

Furthermore, in the disclosure, the inductor 130 is arranged on an electric circuit separate from the semiconductor switch as described above, so that a sufficient space for arranging the inductor 13 can be secured. Thus, there are advantages that an inductor having a larger inductance can be used and that a sufficient space in which a flyback diode, a freewheeling diode, or a resistor of the counter electromotive force elimination circuit 260 is to be arranged can be secured.

Meanwhile, a link capacitor 250 may be further arranged between the input electric circuit 210 and the feedback electric circuit 220 according to the embodiment of the disclosure. For example, the link capacitor 250 may be connected in parallel to the power source unit 160 as shown in FIG. 2A.

In this case, in a state in which the semiconductor switch unit 140 is off, i.e., in a state in which the gate driver 110 applies a gate voltage less than the threshold voltage or does not apply the gate voltage, the control unit 100 may allow the semiconductor switch unit 140 to be repeatedly on/off until the gate voltage reaches a predetermined voltage. Here, a state in which the semiconductor switch unit 140 is on may refer to a state in which the gate driver 110 applies a gate voltage equal to or higher than the threshold voltage.

In this case, the link capacitor 250 may be first charged when the semiconductor switch unit 140 is on. In addition, current charged in the link capacitor 250 may be introduced into the load 150 when the semiconductor switch unit 140 is off. Thus, as a result, a time for which a capacitor in the load 150 is charged becomes long, and the rising speed of a voltage is reduced, so that occurrence of an inrush current can be prevented. In addition, the inductor 130 arranged on the feedback electric circuit 220 functions as a resistor for preventing the occurrence of the inrush current, so that the occurrence of the inrush current can be prevented.

Meanwhile, in the above description, the electric circuit through which the current is input to the load 150 is referred to as the input electric circuit 210, and the electric circuit through which the current is fed back from the load 150 is referred to as the feedback electric circuit 220. However, the input electric circuit 210 may be a positive (P)-phase electric circuit, i.e., a live line or hot line, and the feedback electric circuit 220 may be an N-phase electric circuit, i.e., a neutral line. FIG. 2B illustrates an example of this case.

Referring to FIG. 2B, the semiconductor switch unit 140 may be arranged on the P-phase electric circuit 211. In addition, the inductor 130 may be arranged on the N-phase electric circuit 221. Therefore, as shown in FIG. 2B, the semiconductor switch unit 140 and the inductor 130 according to the embodiment of the disclosure may be arranged on different electric circuits. Alternatively, the semiconductor switch unit 140 and the inductor 130 may be respectively arranged on different electric circuits connected in parallel to the load 150.

Meanwhile, as described in FIGS. 2A and 2B, the inductor 130 of the semiconductor circuit breaker 200 according to the embodiment of the disclosure may be separated from the semiconductor switch unit 140, to be arranged on an electric circuit different from the electric circuit on which the semiconductor switch unit 140 is arranged. For example, the inductor 130 may be arranged on an electric circuit through which the current fed back from the load 150 is output. In this case, in a closed circuit on which the semiconductor circuit breaker 200 according to the embodiment of the disclosure is arranged, the load 150 and the inductor 130 may function as one inductor.

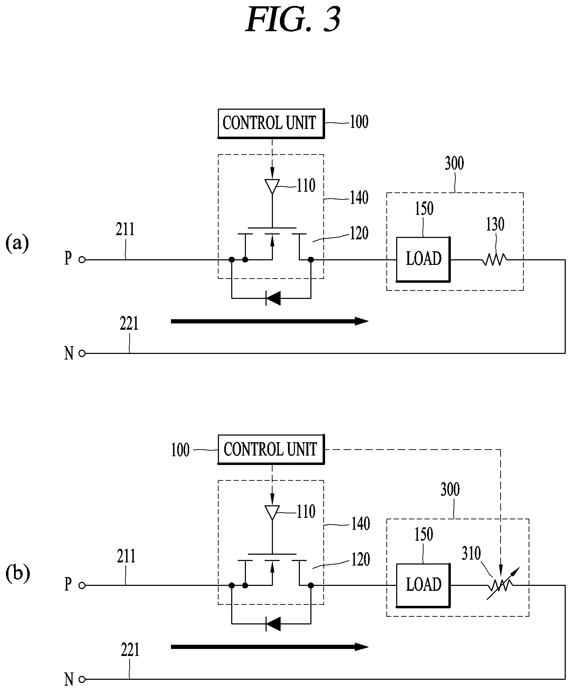

FIG. 3 is a conceptual diagram illustrating a concept in which the load 150 and the inductor 130 form one inductor 300 in a semiconductor circuit breaker according to an embodiment of the disclosure. For example, the load 150 may be an inductive load.

Referring to FIG. 3, first, as shown in FIG. 3A, when the inductor 130 is arranged on the N-phase electric circuit 221 through which current fed back from the load 150 is output, the load 150 and the inductor 130 may be successively connected to each other. That is, the inductor 130 according to the embodiment of the disclosure may have a configuration in which, as shown in FIG. 3A, the load 150 is connected next to the semiconductor switch unit 140 and the inductor 130 is connected successively (in series) next to the load 150.

Meanwhile, when the load 150 is the inductive load, the load 150 may autonomously have an inductance. Therefore, when the load 150 and the inductor 130 are successively connected to each other, a total inductance of a power supply circuit (closed circuit) that supplies power to the load 150 may be a sum of an inductance of the load 150 and an inductance of the inductor 130. Therefore, as shown in FIG. 3A, when the load 150 and the inductor 130 are successively connected to each other, may operate like one inductor (hereinafter, referred to as a synthetic inductor 300). In addition, the rise rate of current supplied through the semiconductor switch unit 140 may be limited according to an inductance provided in the synthetic inductor 300.

Meanwhile, as shown in FIG. 3A, when the load 150 and the inductor 130 are connected to each other to form the synthetic inductor 300, the inductance applied to the semiconductor circuit breaker 200 according to the embodiment of the disclosure may be an inductance obtained by adding the inductance of the load 150 to the inductance of the inductor 130. Thus, there is an advantage that, when the inductance of the load 150 is sufficient, a sufficient inductance can be secured even when the inductance of the inductor 130 is small.

Here, according to the embodiment of the disclosure, the inductor arranged on an electric circuit different from the electric circuit on which the semiconductor switch unit 140 is arranged may be a variable inductor 130 capable of changing an inductance thereof. In addition, since the load 150 also has an inductance when the load 150 is the inductive load, the load 150 and the variable inductor 130 may operate like one inductor (e.g., the synthetic inductor 300) when the variable inductor 130 is connected to the output terminal of the load 150 as shown in FIG. 3B.

Meanwhile, the inductance of the variable inductor 130 may be changed under the control of the control unit 100. Therefore, when the inductance of the load 150 increases or decreases, the control unit 100 may decrease or increase the inductance of the variable inductor 600 by reflecting the inductance of the load 150. Thus, the total inductance of the power supply circuit that supplies power to the load 150 can be constantly maintained. That is, even when the inductance of the load 150 is changed, the semiconductor circuit breaker according to the embodiment of the disclosure has an effect that an optimum inductance required in the semiconductor switch unit 140 can be always maintained through control of the inductance of the variable inductor 130. In addition, there is an advantage that the stability of the power supply circuit can be further improved since a constant inductance can be maintained even in a fluctuation of the load (e.g., a change in inductance).

Meanwhile, in the above description, an example has been described in which power supplied from one power source unit is supplied to the load. Alternatively, the load may be formed to be supplied with power from a plurality of different power source units.

For example, the load may be connected to a commercial power source and may be connected to at least one distributed power generation facility, such as sunlight power generation or geothermal power generation. Alternatively, the load may be connected to at least one uninterruptible power supply systems (USP) or energy storage system (ESS), a battery, or the like. In addition, each of such energy supply systems may operate as a power source unit capable of supplying operating power to a load. In addition, each power source unit may be electrically connected to a load through each semiconductor switch unit including a semiconductor switch.

Here, the power source unit may have a form in which a plurality of energy storage systems are connected in series to each other (e.g., a form in which batteries are connected in series to each other). In the case of the power source unit in which the plurality of energy storage systems are connected in series to each other as described above, the semiconductor switch may be arranged between a plurality of energy storage systems connected in series to each other.

For example, when two energy storage systems are connected in series to each other to constitute a power source unit, the semiconductor switch may be arranged between the two energy storage systems, so that the two energy storage systems are connected to each other via the semiconductor switch. In a case where a plurality of energy storage systems are divided into two parts by the semiconductor switch arranged in the middle thereof as described above, when a short circuit occurs between energy storage systems included in any one part, energy storage systems of the other part, which are connected next to the semiconductor switch, are interrupted by the semiconductor switch, so that the energy storage systems of the other part, in which the short circuit does not occurs, can be protected from a short circuit current.

Meanwhile, the semiconductor circuit breaker 200 according to the embodiment of the disclosure has a separable structure in which the semiconductor switch is arranged in the power source unit that supplies power and the inductor is arranged in the load. Therefore, in the disclosure, when a plurality of power source units are connected to the load, a semiconductor switch unit including at least one semiconductor switch may be arranged in each power source unit, and the inductor may be arranged in the load. In this case, the inductor arranged at a side of the load may provide an inductance commonly applied to the semiconductor switch units respectively arranged in the plurality of power source units. That is, the inductor may be a common inductor that the semiconductor switch units respectively arranged in the plurality of power source units commonly use.

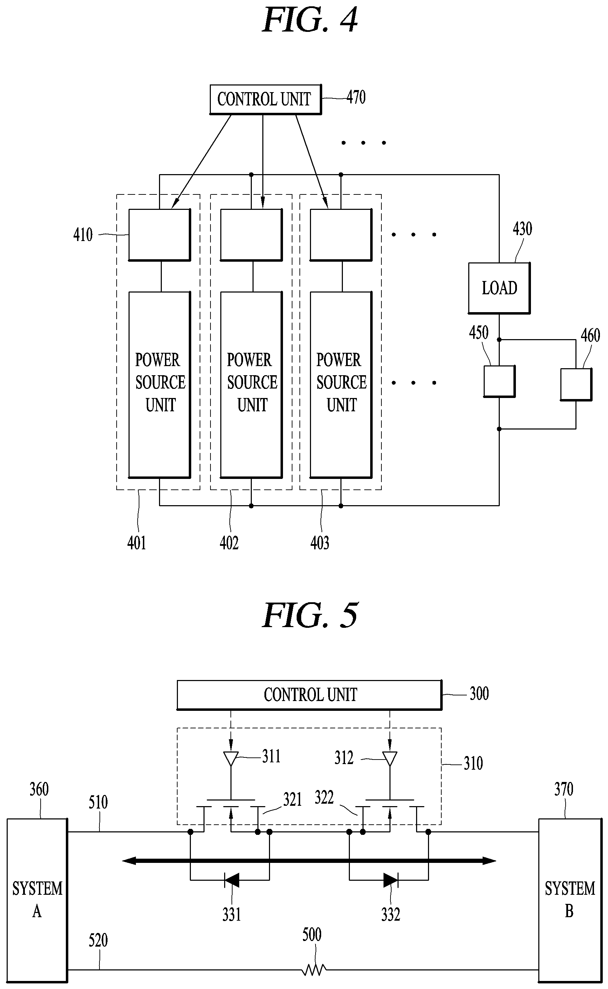

FIG. 4 is a block diagram illustrating a configuration of a power supply system in which semiconductor switch units connected to a plurality of power source units commonly use one inductor according to an inductor separable structure of the above-described semiconductor circuit breaker according to an embodiment of the disclosure.

Referring to FIG. 4, the power supply system according to the embodiment of the disclosure may include a plurality of different power source units 401, 402, 403, ... capable of supplying power to a load 430. Also, the power supply system according to the embodiment of the disclosure may include a control unit 470 that controls gate drivers of semiconductor switch units 410 respectively included in the plurality of power source units such that an electrical connection between the plurality of power source units and the load 430 is made.

Here, the plurality of power source units may be connected in parallel to each other through a bus. In addition, the load 430 may be connected to at least one of the plurality of power source units connected in parallel to each other through the bus, to be supplied with power necessary for driving through the at least one connected power source unit.

In addition, each of the plurality of power source units may include a semiconductor switch unit 410 including at least one semiconductor switch using a power semiconductor to be able to interrupt current supply at high speed when an abnormal current occurs. That is, each of the plurality of power source units may be a configuration including a power source that supplies current and a semiconductor switch unit that connects between the power source and the bus. For example, a first power source unit 401 may include a power source corresponding to the power source unit 160 in FIG. 2A and a semiconductor switch unit 410 corresponding to the semiconductor switch unit 140 in FIG. 2A.

Meanwhile, in according to the above description, the semiconductor circuit breaker according to the embodiment of the disclosure, a semiconductor switch unit and an inductor may be separately arranged on an input electric circuit, e.g., a P-phase electric circuit through which power is supplied to a load and a feedback electric circuit, e.g., an N-phase electric circuit through which current output from the load is fed back, respectively. Therefore, the semiconductor switch units 410 may be respectively included in the plurality of power source units, and an inductor 450 may be arranged at a side of the load 430.

In the disclosure, since the inductor is arranged at the side of the load 430 while being separated from the power source unit as shown in FIG. 4, the inductor 450 may be arranged to be spaced apart from the power source unit.

According to this configuration, when the load 430 is connected to the first power source unit 401 to be supplied with power, the inductor 450 may provide an inductance applied to a first semiconductor switch unit included in the first power source unit 410. In addition, when the load 430 is connected to a second power source unit 402 to be supplied with power, the inductor 450 may provide an inductance applied to a second semiconductor switch unit included in the second power source unit 402. In addition, when the load 430 is connected to a third power source unit 403 to be supplied with power, the inductor 450 may provide an inductance applied to a third semiconductor switch unit included in the third power source unit 403. That is, the inductor 450 may be an inductor that the semiconductor switch units respectively included in the first to third power source units 401 to 403 commonly use. Therefore, the inductor 450 may provide an inductance commonly applied to the semiconductor switch units 410 respectively arranged in the plurality of power source units.

Accordingly, according to the configuration of the semiconductor circuit breaker according to the embodiment of the disclosure, a power supply system is configured in which semiconductor switches connected to a plurality of power sources commonly use one inductor as shown in FIG. 4. Thus, a space for arranging an inductor in each of the plurality of semiconductor switch units is saved, thereby forming a more compact switch of a power source unit.

Furthermore, in the disclosure, the inductor 450 is arranged at the side of the load 430 to be arranged on an electric circuit separate from the electric circuit on which the semiconductor switch unit 410 is arranged as described above. Therefore, a circuit 460 for eliminating a counter electromotive force may also be arranged between both ends of the inductor 450 arranged at the side of the load 430. Hence, the counter electromotive force elimination circuit 460 may also be commonly applied to the semiconductor switch units respectively arranged in the plurality of power source units. Accordingly, a space for the counter electromotive force elimination circuit 460 can be saved in the semiconductor switch unit of each power source unit, so that the size of the semiconductor switch unit including a semiconductor switch in each power source unit can be reduced, and the structure of the semiconductor switch unit can be simplified.

Meanwhile, in the above-described power supply system, when a plurality of power source units are connected to the load 430, the control unit 470 may control an amount of current supplied to the load 430 from each of the plurality power source units through on and off control of a semiconductor switch unit of each of the plurality of power source units connected to the load 430.

That is, current may be supplied to the connected power source unit when the semiconductor switch unit is on, and the supply of the current in the connected power source unit may be interrupted when the semiconductor switch unit is off. The control unit 470 adjusts an on/off switching duty rate of the semiconductor switch unit, to control an amount of current supplied to the load 430 from a specific power source unit for a time corresponding to one duty cycle.

Meanwhile, when a plurality of power source units are connected to the load 430 as described above, the control unit 470 may control an amount of current supplied to the load 430 from each of the plurality of power source units connected to the load 430 according to a condition required in the system.

For example, when current supplied from a distributed power generation facility and current supplied from a commercial power source are the same, a system requirement condition may be assumed in which the current supplied from the distributed power generation facility and the current supplied from the commercial power source are supplied at a ratio of 8:2 to the load 430 (times corresponding to one duty cycle are the same).

In this case, the control unit 470 may perform on/off switching, at a duty rate of 80%, on a semiconductor switch arranged on an electric circuit through which power is supplied from the distributed power generation facility, and may perform on/off switching, at a duty rate of 20%, on a semiconductor switch arranged on an electric circuit through which power is supplied from the commercial power source. Therefore, during one duty cycle, 80% of the current supplied to the load 430 may be supplied from the distributed power generation facility, and the other 20% may be supplied from the commercial power source.

Meanwhile, in the above description, the configuration of the semiconductor switch unit has been described, which controls unidirectional current supply in which current is supplied from the power source unit to the load. However, alternatively, the disclosure may also be applied even when a semiconductor switch unit that controls bidirectional current supply is included.

FIG. 5 is a block diagram illustrating a configuration of a semiconductor circuit breaker including a semiconductor switch unit capable of controlling bidirectional current flow.

Referring to FIG. 5, a semiconductor circuit breaker according to an embodiment of the disclosure may include a semiconductor switch unit 310 including a first semiconductor switch 321 and a second semiconductor switch 322, which are to be turned on/turned off and are connected in series to each other between system A 360 and system B 370.

Here, the system A 360 and the system B 370 may be different power systems. In an example, the system A 360 and the system B 370 may be different micro grids. In this case, bidirectional current flow not only from the system A 360 to the system B 370 but also from the system B 370 to the system A 360 may be formed.

Alternatively, the system A 360 may be a power system and the system B 370 may be a load. In this case, current flow from the system A 360 to the system B 370 may be formed. On the contrary, the system A 360 may be a load and the system B 370 may be a power system. In this case, current flow from the system B 370 to the system A 360 may be formed.

In order to control the bidirectional current flow, the first semiconductor switch 321 and the second semiconductor switch 322 may be formed to be able to break a circuit not only when current flows from the system A 360 to the system B 370 but also when current flows from the system B 370 to the system A 360.

To this end, the first semiconductor switch 321 and the second semiconductor switch 322 may be semiconductor switches each configured as an N-channel MOSFET element having a source and a drain, which are arranged in directions opposite to each other. However, the disclosure is not limited thereto, and the first and second semiconductor switches 321 and 322 may use, in place of the MOSFET element, all elements, e.g., an IGBT, a GTO, an IGCT, and the like, which are to be turned on/turned off by a gate voltage controlled by the control unit 300.

In addition, first and second gate drivers 311 and 312 may apply gate voltages to gate terminals of the first and second semiconductor switches 321 and 322 under the control of the control unit 300, respectively. In this case, when a gate voltage exceeding a threshold voltage is applied to at least one of the first and second semiconductor switches 321 and 322, a resistance of an output terminal of the at least one of the first and second semiconductor switches 321 and 322 may become smaller than that of an input terminal of the at least one of the first and second semiconductor switches 321 and 322. Therefore, the input terminal and the output terminal of the at least one of the first and second semiconductor switches 321 and 322 are conducted, to be electrically connected to each other.

Meanwhile, the first semiconductor switch 321 and the second semiconductor switch 322 may further include, respectively, first and second diodes 331 and 332 arranged in a direction opposite to current flow so as to damage caused by a counter electromotive force when a circuit is broken by an abnormal current. In this case, positive and negative electrodes of the first and second diodes 331 and 332 may be connected to source and drain terminals of the first and second semiconductor switches 321 and 322, respectively.

Therefore, the first diode 331 may be connected in parallel to the first semiconductor switch 321 to be arranged in a direction opposite to the flow of current flowing from the system A to the system B. In addition, the second diode 332 may be connected in parallel to the second semiconductor switch 322 to be arranged in a direction opposite to the flow of current flowing from the system B to the system A.

As such, the semiconductor circuit breaker according to the embodiment of the disclosure includes the first semiconductor switch 321 and the second semiconductor switch 322, which are configured in a complimentary symmetry form, so that both fault currents flowing in both directions can be interrupted.

Meanwhile, as shown in FIG. 5, the semiconductor switch unit 310 and an inductor 500 may be arranged on different electric circuits that connect the system A 360 and the system B 370. For example, when the semiconductor switch unit 310 is arranged on an input electric circuit 510 through which current is supplied between the system A 360 and the system B 370, the inductor 500 may be arranged on another electric circuit, i.e., a feedback electric circuit 520 through which current output from the system B 370 or the system A 360 is fed back. That is, the inductor 500 may be arranged on an electric circuit separate from the electric circuit on which the semiconductor switch unit 310 is arranged to be separated from the semiconductor switch unit 310.

Meanwhile, in the semiconductor circuit breaker according to the embodiment of the disclosure, the inductor may be a variable inductor. In this case, the control unit 300 may control the inductance of the variable inductor, thereby constantly maintaining an inductance applied to a power supply circuit shown in FIG. 5.

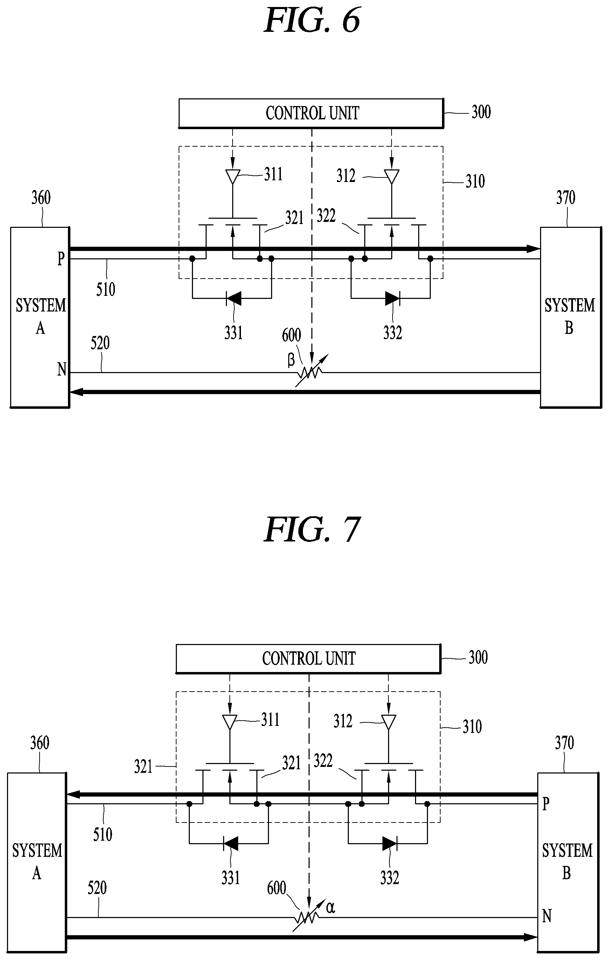

First, FIG. 6 is an exemplary diagram illustrating an example in which current is supplied from the system A 360 to the system B 370 in the semiconductor circuit breaker of FIG. 5.

Referring to FIG. 6, in the semiconductor circuit breaker according to the embodiment of the disclosure shown in FIG. 5, the control unit 300 may control the gate drivers 311 and 312 such that gate voltages equal to or higher than the threshold voltage are applied to the gate terminals of the first and second semiconductor switches 321 and 322, respectively. Then, the system A 360 and the system B 370 may be electrically connected to each other through the semiconductor switch unit 310, and current of the system A 360 may be supplied to the system B 370.

When the current is supplied from the system A 360 to the system B 370 as described above, the system A 360 may correspond to a power source unit and the system B 370 may be a load. Then, a variable inductor 600 may be arranged on the feedback electric circuit through which the current supplied from the system A 360 is output from the system B 370 to be fed back to the system A 360. In this case, a sum of an inductance of the variable inductor 600 and an inductance of the system B 370 may form the inductance applied to the power supply circuit.

Therefore, the control unit 300 may calculate a first inductance β for constantly maintaining the inductance of the power supply circuit, based on the inductance of the system B 370 corresponding to the load. In addition, the inductance of the variable inductor 600 is changed according to the calculated first inductance β, so that the inductance of the power supply circuit can be constantly maintained.

FIG. 7 is an exemplary diagram illustrating, on the contrary to FIG. 6, an example in which current is supplied from the system B 370 to the system A 360 in the semiconductor circuit breaker of FIG. 5.

Referring to FIG. 7, in the semiconductor circuit breaker according to the embodiment of the disclosure shown in FIG. 5, the control unit 300 may control the gate drivers 311 and 312 such that gate voltages equal to or higher than the threshold voltage are applied to the gate terminals of the first and second semiconductor switches 321 and 322, respectively. Then, the system A 360 and the system B 370 may be electrically connected to each other through the semiconductor switch unit 310, and current of the system B 370 may be supplied to the system A 360.

When the current is supplied from the system B 370 to the system A 360 as described above, the system B 370 may correspond to a power source unit and the system A 360 may be a load. Then, the variable inductor 600 may be arranged on the feedback electric circuit through which the current supplied from the system B 370 is output from the system A 360 to be fed back to the system B 370. In this case, a sum of an inductance of the variable inductor 600 and an inductance of the system A 360 may form the inductance applied to the power supply circuit.

Therefore, the control unit 300 may calculate a second inductance α for constantly maintaining the inductance of the power supply circuit, based on the inductance of the system A 360 corresponding to the load. In this case, when the inductance of the system B 370 is larger than the inductance of the system A 360, the control unit 300 may calculate the second inductance α larger than the first inductance β. In addition, the inductance of the variable inductor 600 may be changed according to the calculated second inductance α. Thus, in the disclosure, even when current is supplied between systems having different inductances, the inductance applied to the power supply circuit can be constantly maintained.

Meanwhile, in the above description of the disclosure, specific embodiments have been described. However, various modifications may be embodied without departing from the spirit and scope of the disclosure. Particularly, in the embodiment of the disclosure, the semiconductor switch unit including one semiconductor switch when current is supplied in a single direction is described as an example. However, alternatively, the semiconductor switch unit may include a plurality of semiconductor switches even when the current is supplied in a single direction.

Meanwhile, the semiconductor circuit breaker according to the embodiment of the disclosure may further include a cut-off switch capable of physically connecting or separating the semiconductor switch unit to or from the power supply circuit that supplies power to a load. In this case, the cut-off switch may be controlled by the control unit to be driven while the semiconductor switch is off in occurrence of an abnormal current such as a short circuit or current leakage. In this case, since the semiconductor switch operates a high speed as compared with the cut-off switch, the semiconductor switch opens the input electric circuit before the cut-off switch interrupts the semiconductor switch unit, thereby blocking the abnormal current from being introduced into the load, and the semiconductor switch unit can be physically blocked from the input electric circuit in the input electric circuit is opened.

The disclosure described above may be implemented as a computer readable code in a program recording medium. The computer readable medium includes all kinds of record devices that store data that may be read by a computer system. The computer readable medium may include, for example, a Hard Disk Drive (HDD), a Solid State Disk (SSD), a Silicon Disk Drive (SDD), a ROM, a RAM, a CD-ROM, a magnetic tape, a floppy disk, an optical data storage device, and the like, and may also include a medium implemented in the form of a carrier wave (e.g., transmission through Internet). In addition, the computer may include a controller of a terminal. Accordingly, the detailed description should not be construed as being limitative from all aspects, but should be construed as being illustrative. The scope of the disclosure should be determined by reasonable analysis of the attached claims, and all changes within the equivalent range of the disclosure are included in the scope of the disclosure.

## Claims

1. A semiconductor circuit breaker (solid state circuit breaker) arranged between a power source and a load, the semiconductor circuit breaker comprising:
a semiconductor switch unit arranged on an input electric circuit through which current is supplied from the power source to the load, and comprising at least one semiconductor switch that opens or closes the input electric circuit;
a control unit configured to a gate driver of the at least one semiconductor switch, thereby controlling the opening or closing of the input electric circuit; and
at least one inductor arranged on a feedback electric circuit through which the current output from the load is fed back to the power source, as an electric circuit separate from the input electric circuit on which the semiconductor switch unit is arranged.

2. The semiconductor circuit breaker of claim 1, wherein the input electric circuit is a positive (P)-phase electric circuit which is a live line, and the feedback electric circuit is a negative (N)-phase electric circuit which is a neutral line.

3. The semiconductor circuit breaker of claim 1, wherein the at least one inductor is arranged between an output terminal of the load and the power source, and is connected in series to the load at a rear end of the load.

4. The semiconductor circuit breaker of claim 1, wherein the at least one semiconductor switch comprises a rectifying element arranged in a direction opposite to a direction in which the semiconductor switch is arranged, and
wherein the rectifying element comprises at least one of a diode, a rectifier, or a thyristor.

5. The semiconductor circuit breaker of claim 1, wherein the semiconductor switch is configured as an insulated gate bipolar transistor (IGBT) or a metal oxide semiconductor field effect transistor (MOSFET).

6. The semiconductor circuit breaker of claim 1, wherein a counter electromotive force elimination circuit for eliminating a counter electromotive force generated when current supply is suspended due to off of the semiconductor switch is further arranged on an electric circuit different from the electric circuit on which the semiconductor switch unit is arranged.

7. The semiconductor circuit breaker of claim 6, wherein the counter electromotive force elimination circuit:
is connected to both ends of the inductor arranged on an electric circuit different from the electric circuit on which the semiconductor switch unit is arranged; and
comprises at least one diode having a polarity arranged in a direction opposite to a direction the current flows through the electric circuit on which the inductor is arranged.

8. The semiconductor circuit breaker of claim 1, wherein a link capacitor connected in parallel to the power source is further arranged between the input electric circuit and the feedback electric circuit.

9. The semiconductor circuit breaker of claim 1, wherein the semiconductor switch unit comprises first and second semiconductor switches arranged between a first power system and a second power system, connected in series to each other, and arranged in directions opposite to each other, and
wherein any one of the first power system and the second power system is a power source that supplies current to the other of the first power system and the second power system, and the other of the first power system and the second power system operates as a load supplied with the current from the one of the first power system and the second power system.

10. The semiconductor circuit breaker of claim 1, wherein the inductor is a variable inductor in which a change in inductance thereof is possible, and
wherein, when the load is changed, the control unit changes the inductance of the variable inductor such that a total inductance obtained by summing up an inductance of the changed load and the inductance of the variable inductor forms a predetermined inductance.

11. The semiconductor circuit breaker of claim 10, wherein the load is an inductive load.

12. A power supply system comprising a plurality of power sources that supply power to a load, the power supply system comprising:
a bus configured to connect the plurality of power sources in parallel to each other, and connect the plurality of power sources connected in parallel to each other and the load;
a plurality of semiconductor switch units arranged between the respective power sources and the bus, and each comprising at least one semiconductor switch that opens or closes an electric circuit through which current is supplied from each power source to the bus;
a control unit configured to control gate drivers of the semiconductor switches respectively included in the plurality of semiconductor switch units, thereby controlling the opening or closing of each electric circuit through which the current is supplied from the power source to the bus; and
a common inductor arranged at an output terminal of the load, and providing an inductance commonly applied to the plurality of semiconductor switch units.

13. The power supply system of claim 12, further comprising a counter electromotive force elimination circuit connected to both ends of the common inductor, and comprising at least one diode having a polarity arranged in a direction opposite to a direction the current flows through the electric circuit on which the common inductor is arranged.

14. The power supply system of claim 12, wherein a first power source among the plurality of power sources comprises two or more energy storage systems connected in series to each other, and
wherein a semiconductor switch unit arranged between the first power source and the bus is arranged in the middle of the two or more energy storage systems connected in series to each other.

15. The power supply system of claim 12, wherein the control unit differently controls a duty rate which is a rate of a time for which the semiconductor switch unit is on and a time for which the semiconductor switch unit is off during a predetermined time according to the plurality of power sources such that a ratio of amounts of current that the plurality of power sources supply to the load is changed.
